# EUROPÄISCHE PATENTANMELDUNG

(11) **EP 1 193 598 A1**
(43) Veröffentlichungstag der Anmeldung: **03.04.2002**
(21) Anmeldenummer: 01114671.9
(22) Anmeldetag: 19.06.2001
(51) Int. Cl.: G06F 11/20

(54) **Intergrierter Speicher mit Speicherzellen mit magnetoresistivem Speichereffekt**

(30) Priorität: 03.07.2000 DE 10032274
(71) Anmelder: Infineon Technologies AG, 81669 München (DE)
(72) Erfinder: Pöchmüller, Peter, Colchester, VT 05446 (US)
(74) Vertreter: Epping Hermann & Fischer

(57) **Zusammenfassung**

Ein integrierter Speicher weist Speicherzellen (MC) mit magnetoresistivem Speichereffekt auf, die jeweils zwischen eine Spaltenleitung (BL0 bis BLn) und eine Zeilenleitung (WL0 bis WLm) geschaltet sind. Die Zeilenleitungen (WL2) sind mit einem Anschluß für ein Auswahlsignal (GND) verbindbar zum Auslesen eines Datensignals (DA) einer der Speicherzellen (MC3) oder Schreiben eines Datensignals (DA) in eine der Speicherzellen (MC3) über die mit der Speicherzelle (MC3) verbundene Spaltenleitung (BL2). Eine oder mehrere der nicht mit der Speicherzelle (MC3) verbundenen Spaltenleitungen (BL0, BL1, BLn) sind derart ansteuerbar, daß sie zum Auslesen oder Schreiben des Datensignals (DA) in dem Leseverstärker (3) elektrisch isoliert sind. Dadurch ist im Falle einer vorhandenen fehlerhaften Speicherzelle (MC2) ein ordnungsgemäßes Auslesen oder Schreiben des Datensignals (DA) der Speicherzelle (MC3) ermöglicht.

## Beschreibung

Integrierter Speicher mit Speicherzellen mit magnetoresistivem Speichereffekt

Die vorliegende Erfindung betrifft einen integrierten Speicher mit Speicherzellen mit magnetoresistivem Speichereffekt, die zwischen jeweils eine von mehreren Spaltenleitungen und jeweils eine von mehreren Zeilenleitungen geschaltet sind, bei dem die Spaltenleitungen mit einem Leseverstärker verbunden sind und bei dem die Zeilenleitungen jeweils mit einem Anschluß für ein Auswahlsignal verbindbar sind zum Auslesen eines Datensignals einer der Speicherzellen oder Schreiben eines Datensignals in eine der Speicherzellen über die mit der Speicherzelle verbundene Spaltenleitung.

Speicherzellen mit magnetoresisitvem Speichereffekt weisen zur Speicherung von Datensignalen im allgemeinen in ihrem Zustand veränderbare ferromagnetische Schichten auf. Dieser Speichereffekt ist allgemein als sogenannter GMR-Effekt (giant magnetoresistive) oder TMR-Effekt (tunneling magneto-resitive)bekannt. Dabei ist der elektrische Widerstand einer derartigen Speicherzelle abhängig von der Magnetisierung in den ferromagnetischen Schichten.

Integrierte Speicher mit derartigen Speicherzellen, auch als sogenannte MRAM-Speicher bezeichnet, sind oftmals ähnlich aufgebaut wie beispielsweise integrierte Speicher vom Typ DRAM. Derartige Speicher weisen im allgemeinen eine Speicherzellenanordnung mit untereinander im wesentlichen parallel verlaufenden Zeilenleitungen und Spaltenleitungen auf, wobei die Zeilenleitungen üblicherweise quer zu den Spaltenleitungen verlaufen.

Ein derartiger MRAM-Speicher ist aus WO 99/14760 bekannt. Dort sind die Speicherzellen jeweils zwischen eine der Zeilenleitungen und eine der Spaltenleitungen geschaltet und mit der jeweiligen Spaltenleitung und Zeilenleitung elektrisch verbunden. Die Speicherzellen mit magnetoresistivem Speichereffekt sind dabei hochohmiger als die Zeilenleitungen und Spaltenleitungen. Die Zeilenleitungen sind jeweils mit einem Anschluß für ein Auswahlsignal verbunden zum Auslesen eines Datensignals einer der Speicherzellen oder Schreiben eines Datensignals in eine der Speicherzellen über die mit der Speicherzelle verbundene Spaltenleitung. Die Spaltenleitungen sind zum Auslesen eines Datensignals einer der Speicherzellen mit einem Leseverstärker verbunden. Zum Auslesen wird der auf der Spaltenleitung detektierbare Strom gemessen.

Bei einem derartigen MRAM-Speicher sind keine Dioden oder Transistoren vorhanden, die zum Auslesen oder Schreiben eines Datensignals die Speicherzellen abhängig von der Adressierung mit der jeweiligen Spaltenleitung verbinden. Dadurch erhält man insbesondere Vorteile bei der geometrischen Anordnung der Speicherzellen.

Infolge von herstellungsbedingten Einflüssen wie beispielsweise Prozeßschwankungen oder infolge von Alterung ist es möglich, daß einzelne der Speicherzellen einen unerwünschten vergleichsweise niedrigen Widerstand aufweisen und damit fehlerhaft sind. Über derartige fehlerhafte Speicherzellen sind jeweilige angeschlossene Spaltenleitungen und Zeilenleitungen im wesentlichen kurzgeschlossen. Durch einen solchen Kurzschluß sind auch weitere Speicherzellen entlang dieser Spaltenleitung beziehungsweise Zeilenleitung betroffen. Weiterhin können in einem Funktionstest infolge eines Kurzschlusses durch eine der Speicherzellen andere Speicherzellen, welche entlang von betroffenen Leitungen liegen, nicht mehr getestet werden. Bei einer Reparatur eines Speichers mit einer defekten Speicherzelle läßt sich das Problem nicht durch Ersetzen einer einzelnen betroffenen Zeilenleitung oder Spaltenleitung beseitigen, da die Speicherzellen der anderen betroffenen Leitung nach wie vor durch den Kurzschluß in ihrer Funktion beeinträchtigt sind. Außerdem werden durch den nach wie vor vorhandenen Kurzschluß auch auf anderen Leitungen parasitäre Ströme verursacht, die einen Auslese- oder Schreibvorgang negativ beeinflussen können. Es sind in diesem Falle daher beide betroffenen Leitungen einer fehlerhaften Speicherzelle zu ersetzen.

Die Aufgabe der vorliegenden Erfindung ist es, einen integrierten Speicher der eingangs genannten Art anzugeben, bei dem im Falle einer vorhandenen fehlerhaften Speicherzelle, die einen Kurzschluß zwischen einer Zeilenleitung und einer Spaltenleitung auslöst, ein ordnungsgemäßes Auslesen beziehungsweise Schreiben von Datensignalen von restlichen Speicherzellen weitgehend ermöglicht ist.

Die Aufgabe wird gelöst durch einen integrierten Speicher gemäß Patentanspruch 1.

Weitere vorteilhafte Aus- und Weiterbildungen sind in den Unteransprüchen angegeben.

Bei dem erfindungsgemäßen integrierten Speicher ist es möglich, bei Auftreten von fehlerhaften Speicherzellen, die einen Kurzschluß zwischen der jeweiligen angeschlossenen Zeilenleitung und Spaltenleitung auslösen, die betroffene Spaltenleitung in dem Leseverstärker so abzutrennen, daß die entsprechende angeschlossene Zeilenleitung weiterbetrieben werden kann. Die an einer fehlerhaften Speicherzelle angeschlossene Zeilenleitung kann beispielsweise für einen Normalbetrieb oder Testbetrieb des integrierten Speichers weiterverwendet werden. Da die entsprechende Spaltenleitung in dem Leseverstärker nach dem Abtrennen eine Art schwebenden oder floatenden Zustand aufweist, kann sie über die kurzgeschlossene Speicherzelle auf das Potential der an der fehlerhaften Speicherzelle angeschlossenen Zeilenleitung gebracht werden. Dadurch wird ein Auslesevorgang oder Schreibvorgang über die betreffende Zeilenleitung nicht mehr durch die fehlerhafte Speicherzelle negativ beeinflußt. Der Aufwand zum Abtrennen der betreffenden Spaltenleitung in dem Leseverstärker ist dabei relativ gering. Es ist für eine eventuelle Reparatur nur die betreffende Spaltenleitung zu ersetzen.

In einer Ausführungsform des erfindungsgemäßen Speichers sind die Spaltenleitungen mit einer jeweiligen Treiberschaltung verbunden, die in einem leitenden Zustand oder nicht leitenden Zustand betreibbar ist. Über diese Treiberschaltungen sind die Spaltenleitungen so ansteuerbar, daß sie zum Auslesen oder Schreiben des Datensignals elektrisch isoliert sind. Dazu werden die Treiberschaltungen in dem nicht leitenden Zustand betrieben. Die jeweilige Treiberschaltung weist beispielsweise Schaltmittel in Form von Transistoren auf, die über ihre Source-Drain-Strecken mit der jeweiligen Spaltenleitung verbunden sind. Diese Transistoren werden in einem entsprechenden nicht leitenden Zustand betrieben.

In einer Weiterbildung der Erfindung ist der jeweiligen Treiberschaltung eine Speichereinheit zugeordnet, durch die die jeweilige Treiberschaltung ansteuerbar ist. In der jeweiligen Speichereinheit kann eine Information gespeichert werden, beispielsweise welche der Spaltenleitungen jeweils mit einer fehlerhaften Speicherzelle verbunden sind. Die jeweilige Speichereinheit generiert dabei ein entsprechendes Steuersignal für die jeweilige zugeordnete Treiberschaltung. Die Speichereinheiten weisen beispielsweise jeweils ein elektrisch programmierbares Element oder ein durch einen Energiestrahl programmierbares Element auf. Das letztere kann beispielsweise in Form einer sogenannten Laserfuse ausgebildet sein, die mittels eines Laserstrahls programmierbar ist. Die zu speichernde Information kann mit derartigen programmierbaren Elementen dauerhaft gespeichert werden, so daß ein Funktionstest zur Detektion von fehlerhaften Speicherzellen nur einmal durchgeführt werden muß.

Der integrierte Speicher weist vorzugsweise zur Reparatur von fehlerhaften Speicherzellen redundante Speicherzellen auf, die zu wenigstens einer redundanten Spaltenleitung zusammengefaßt sind, die eine reguläre Spaltenleitung mit defekten Speicherzellen adressenmäßig ersetzen kann. Dabei wird der integrierte Speicher beispielsweise mit einer externen Prüfeinrichtung geprüft und anschließend anhand einer sogenannten Redundanzanalyse eine Programmierung der redundanten Elemente vorgenommen. Eine Redundanzschaltung weist dann programmierbare Elemente zum Beispiel in Form von programmierbaren Fuses auf, die zum Speichern der Adresse einer zu ersetzenden Leitung dienen.

Zur Reparatur des integrierten Speichers im Falle einer vorhandenen fehlerhaften Speicherzelle reicht es aus, nur die betroffene Spaltenleitung durch eine redundante Spaltenleitung zu ersetzen. Da die vom Kurzschluß betroffene Spaltenleitung im Leseverstärker beim Auslesen oder Schreiben elektrisch isoliert ist, kann die betroffene Zeilenleitung weiterbetrieben werden. Dadurch ist der Reparaturaufwand vorteilhaft reduzierbar.

Weist der integrierte Speicher mehrere redundante Zeilenleitungen und Spaltenleitungen auf, so kann im Falle einer vorhandenen fehlerhaften Speicherzelle mit einem Funktionstest für die restlichen Speicherzellen fortgefahren werden, wenn die an der fehlerhafte Speicherzelle angeschlossene Spaltenleitung zuvor isoliert wird. Auf diese Weise kann eine Vielzahl von Speicherzellen des integrierten Speichers getestet werden, auch wenn zwischendurch fehlerhafte Speicherzellen auftreten. Dies hat den Vorteil, daß anhand einer nachfolgenden Redundanzanalyse eine gezielte optimierte Programmierung der redundanten Leitungen vorgenommen werden kann. Da die Anzahl der redundanten Leitungen meist begrenzt ist, kann auf diese Weise die Ausbeute von herzustellenden integrierten Speichern erhöht werden.

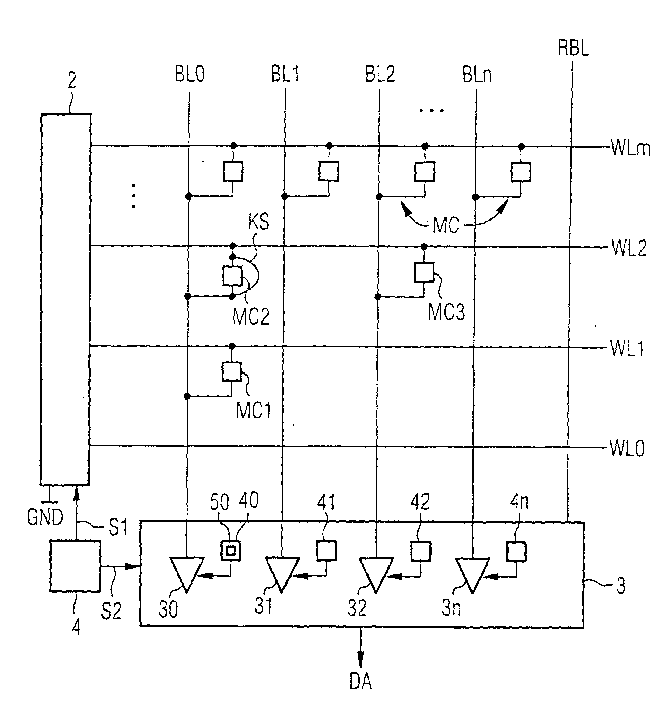

Die Erfindung wird im folgenden anhand der in der Zeichnung dargestellten Figur näher erläutert.

Die Figur zeigt ein Ausführungsbeispiel eines MRAM-Speichers mit Speicherzellen MC mit magnetoresistivem Speichereffekt. Als Speicherzellen sind alle bekannten GMR-/TMR-Elemente geeignet, sofern sie hochohmiger sind als die Spaltenleitungen und die Zeilenleitungen. Die Spaltenleitungen sind hier als Bitleitungen BL0 bis BLn bezeichnet, die Zeilenleitungen als Wortleitungen WL0 bis WLm. Der Speicher weist hier eine beispielhafte Anzahl von Wortleitungen und Bitleitungen auf. Die Speicherzellen MC, die in einem matrixförmigen Speicherzellenfeld 1 angeordnet sind, sind jeweils zwischen eine der Bitleitungen BL0 bis BLn und eine der Wortleitungen WL0 bis WLm geschaltet.

Zum Einschreiben einer Information beziehungsweise eines Datensignals in eine der Speicherzellen MC werden die entsprechende angeschlossene Bitleitung und Wortleitung mit einer jeweiligen Stromquelle verbunden, die in der Figur nicht dargestellt ist. Durch die in den entsprechenden Leitungen fließenden Ströme wird an dem Kreuzungspunkt der Leitungen, an dem die betreffende Speicherzelle MC angeordnet ist, ein resultierendes überlagertes Magnetfeld erzeugt, das eine magnetische Schicht der betreffenden Speicherzelle in einem bestimmten Zustand versetzt. Die Speicherzelle weist dabei eine magnetische Hysterese auf.

Zum Auslesen eines Datensignals aus einer der Speicherzellen MC ist die entsprechende Bitleitung mit dem Leseverstärker 3 verbunden. Zum Auslesen wird die betroffene Wortleitung durch die Zeilenauswahlschaltung 2 angesteuert und über Schaltmittel mit einem vorgegebenen Auswahlsignal beziehungsweise Auswahlpotential, beispielsweise einer Bezugsspannung GND = 0V, beaufschlagt, so daß ein Stromfluß durch die auszulesende Speicherzelle auftritt. Alle anderen Wortleitungen sowie jeweilige Bitleitungen werden auf ein Potential beispielsweise V1 = 0,5V gelegt. Der Stromfluß durch die Speicherzelle wird durch den Leseverstärker 3 an der entsprechenden Bitleitung detektiert.

Die in der Figur gezeigte Speicherzelle MC2 ist an der Wortleitung WL2 und Bitleitung BL0 anschlossen. Die Speicherzelle MC2 sei als fehlerhaft angenommen. Über die Speicherzelle MC2 sind die Bitleitung BL0 und die Wortleitung WL2 kurzgeschlossen, in der Figur schematisch dargestellt durch einen Kurzschlußbogen KS. Bleibt dieser Kurzschluß beispielsweise während eines Normalbetriebs des Speichers bestehen, so kann bei einer Auswahl von Speicherzellen entlang der Wortleitung WL2 in der oben beschriebenen Betriebsweise kein ordnungsgemäßer Auslesevorgang erfolgen: Beispielsweise wird zum Auslesen eines Datensignals der Speicherzelle MC2 die Wortleitung WL2 mit dem Auswahlpotential GND = 0V verbunden. Die anderen Wortleitungen WL0, WL1 und WLm sind mit dem Potential V1 = 0,5V verbunden. Ebenso sind die Bitleitungen BL0 bis BLn mit dem Potential V1 = 0,5V verbunden. Durch die kurzgeschlossene Speicherzelle MC2 wird der Potentialpegel der Wortleitung WL2 verändert. Dieser Potentialpegel wird sich zwischen 0V und 0,5V einpendeln, abhängig von dem verbleibenden Widerstandswert der Speicherzelle MC2. Soll in diesem Fall eine Information der Speicherzelle MC3 ausgelesen werden, so kann ein durch den Leseverstärker 3 zu detektierender Stromfluß infolge des veränderten Potentialpegels verfälscht werden. In diesem Fall ist kein ordnungsgemäßer Auslesevorgang der Speicherzelle MC3 möglich.

Es ist in diesem Fall nicht ausreichend, die Bitleitung BL0 durch eine redundante Bitleitung zu ersetzen. Da die Wortleitung WL2 und Bitleitung BL0 nach wie vor kurzgeschlossen sind, kann entlang der Wortleitung WL2 kein ordnungsgemäßer Auslesevorgang erfolgen. In diesem Fall muß die Wortleitung WL2 ebenfalls durch eine redundante Wortleitung ersetzt werden. Dies hat zur Folge, daß beispielsweise die Speicherzelle MC3 nicht mehr über die Bitleitung BL2 ausgelesen oder beschreiben werden kann.

Die Auswahlschaltung 2 und der Leseverstärker 3 werden durch die Zugriffssteuerung 4 als Steuermittel beziehungsweise deren Signale S1 und S2 angesteuert. Wie beschrieben, ist zum Auslesen des Datensignals DA der Speicherzelle MC3 über die mit der Speicherzelle MC3 verbundene Bitleitung BL2 die Zeilenleitung WL2 mit dem Auswahlpotential GND verbunden. Erfindungsgemäß wird die vom Kurzschluß betroffene Bitleitung BL0 derart angesteuert, daß sie zum Auslesen des Datensignals DA der Speicherzelle MC3 in dem Leseverstärker 3 isoliert ist. Diese Bitleitung weist im Leseverstärker 3 also eine Art schwebenden oder floatenden Zustand auf. Die an der kurzgeschlossenen Speicherzelle MC2 angeschlossene Bitleitung BL0 wird zum Auslesen des Datensignals DA der Speicherzelle MC3 demnach über die Speicherzelle MC2 auf das Potential GND = 0V entladen. Sobald dieser Zustand erreicht ist, kann das Auslesen der Speicherzelle MC3 über die Bitleitung BL2 erfolgen. Die Wortleitung WL2 beziehungsweise deren Potentialpegel wird zu diesem Zeitpunkt nicht mehr durch die fehlerhafte Speicherzelle MC2 beeinflußt.

In der Figur ist außerdem eine Ausführungsform des Leseverstärkers 3 gezeigt. Die Bitleitungen BL0 bis BLn sind jeweils mit Treiberschaltungen 30 bis 3n verbunden. Die Treiberschaltung 30 bis 3n sind dabei gleich aufgebaut. Sie weisen beispielsweise Schalttransistoren auf, die in einem leitenden Zustand oder in einem nicht leitenden Zustand betreibbar sind. Über die Treiberschaltungen 30 bis 3n können die Bitleitungen BL0 bis BLn beispielsweise mit dem Potential V1 beaufschlagt werden. Die Treiberschaltung 30 bis 3n beziehungsweise deren Schalttransistoren sind dazu in einem entsprechenden leitenden Zustand. Um die jeweiligen Bitleitungen BL0 bis BLn in dem Leseverstärker 3 elektrisch zu isolieren, werden die entsprechenden Treiberschaltungen 30 bis 3n beziehungsweise deren Schalttransistoren in einem entsprechenden nicht leitenden Zustand betrieben.

Den jeweiligen Treiberschaltungen 30 bis 3n sind jeweilige Speichereinheiten 40 bis 4n zugeordnet. Die Treiberschaltungen sind dabei durch die Speichereinheiten ansteuerbar. Die Speichereinheiten 40 bis 4n weisen beispielsweise jeweils ein elektrisch programmierbares Element 50 auf, in dem eine zu speichernde Information dauerhaft speicherbar ist. Beispielsweise ist in der Speichereinheit 40 eine entsprechende Information gespeichert, daß die Bitleitung BL0 beim Auslesen des Datensignals DA in dem Leseverstärker 3 entsprechend zu isolieren ist, da sie mit der fehlerhaften Speicherzelle MC2 verbunden ist.

Die Speicherzellen MC des Speicherzellenfeldes 1 werden beispielsweise in einem Funktionstest hinsichtlich deren Funktionsfähigkeit geprüft. Wird dabei eine fehlerhafte Speicherzelle MC festgestellt, so kann die entsprechende Bitleitung in der beschriebenen Art angesteuert werden. Das Speicherzellenfeld 1 kann dadurch vollständig getestet werden, ohne daß ein Auslesevorgang oder Schreibvorgang von einem Kurzschluß negativ beeinflußt ist. Bei Auftreten einer fehlerhaften Speicherzelle MC kann eine betroffene Bitleitung BL0 bis BLn durch die gezeigte redundante Bitleitung RBL ersetzt werden. Bei einer Reparatur mit der redundanten Bitleitung RBL braucht nur die betroffene Bitleitung (im Beispiel die Bitleitung BL0) ersetzt zu werden.

## Patentansprüche

1. Integrierter Speicher
- mit Speicherzellen (MC) mit magnetoresistivem Speichereffekt, die zwischen jeweils eine von mehreren Spaltenleitungen (BL0 bis BLn) und jeweils eine von mehreren Zeilenleitungen (WL0 bis WLm) geschaltet sind,
- bei dem die Spaltenleitungen (BL0 bis BLn) mit einem Leseverstärker (3) verbunden sind,
- bei dem die Zeilenleitungen (WL0 bis WLm) jeweils mit einem Anschluß für ein Auswahlsignal (GND) verbindbar sind zum Auslesen eines Datensignals (DA) einer ausgewählten Speicherzelle (MC3) oder Schreiben eines Datensignals (DA) in eine ausgewählte Speicherzelle (MC3) über die mit der ausgewählten Speicherzelle (MC3) verbundene Spaltenleitung (BL2),
**dadurch gekennzeichnet, daß**
der Leseverstärker (3) derart ausgebildet und durch Steuermittel (4) ansteuerbar ist, daß wenigstens eine der nicht mit der ausgewählten Speicherzelle (MC3) verbundenen Spaltenleitungen (BL0), die mit wenigstens einer defekten Speicherzelle (MC2) verbunden ist, durch die ein Kurzschluß (KS) zwischen jeweils einer der Zeilenleitungen (WL2) und Spaltenleitungen (BL0) verursacht ist, zum Auslesen oder Schreiben des Datensignals (DA) in dem Leseverstärker (3) elektrisch isoliert ist.

2. Integrierter Speicher nach Anspruch 1,
**dadurch gekennzeichnet, daß**
die Spaltenleitungen (BL0 bis BLn) mit einer jeweiligen Treiberschaltung (30 bis 3n) verbunden sind, die in einem leitenden Zustand oder in einem nicht leitenden Zustand betreibbar ist.

3. Integrierter Speicher nach Anspruch 2,
**dadurch gekennzeichnet, daß**
der jeweiligen Treiberschaltung (30 bis 3n) eine Speichereinheit (40 bis 4n) zugeordnet ist, durch die die Treiberschaltung (30 bis 3n) ansteuerbar ist.

4. Integrierter Speicher nach Anspruch 3,
**dadurch gekennzeichnet, daß**
die Speichereinheit (40 bis 4n) wenigstens ein elektrisch programmierbares oder ein durch einen Energiestrahl programmierbares Element (50) aufweist.

5. Integrierter Speicher nach einem der Ansprüche 1 bis 4,
**dadurch gekennzeichnet, daß**
der integrierte Speicher wenigstens eine redundante Spaltenleitung (RBL) aufweist zum Ersetzen einer der Spaltenleitungen (BL0 bis BLn).
